# EUROPEAN PATENT SPECIFICATION

(11) **EP 1 893 986 B1**
(45) Date of publication and mention of the grant of the patent: **28.08.2013**
(21) Application number: 06756200.9
(22) Date of filing: 07.06.2006
(51) Int. Cl.: G01N 24/08, G01R 33/44, G01R 33/30, G01R 33/385

(54) **A PORTABLE QUALITY AND PROCESS CONTROL SYSTEM FOR SIMULTANEOUS MAGNETIC RESONANCE IMAGING OF MULTIPLE SAMPLES**
TRAGBARES QUALITÄTS- UND PROZESSÜBERWACHUNGSSYSTEM ZUR GLEICHZEITIGEN MAGNETRESONANZBILDGEBUNG MEHRERER PROBEN
SYSTEME PORTABLE DE CONTROLE DE QUALITE ET DE PROCESSUS D IMAGERIE PAR RESONANCE MAGNETIQUE SIMULTANEE SUR UNE PLURALITE D ECHANTILLONS

(30) Priority: 09.06.2005 US 688761 P; 19.07.2005 US 184249; 03.11.2005 US 732653 P; 03.11.2005 US 732652 P; 03.11.2005 US 732702 P; 03.11.2005 US 732709 P; 03.11.2005 US 732701 P
(43) Date of publication of application: 05.03.2008
(73) Proprietor: Aspect Magnet Technologies Ltd., 73115 Ben Shemen (IL)
(72) Inventor: Rapoport, Uri, 73115 Ben Shemen (IL)
(74) Representative: Lecomte & Partners
(86) International application number: PCT/IL2006/000659
(87) International publication number: WO 2006/131918

(56) References cited:
- EP-A- 0 726 458
- EP-A- 1 253 433
- EP-A- 1 477 822
- EP-A2- 1 411 366
- WO-A-02/059586
- GB-A- 2 120 075
- JP-A- 2 110 360
- JP-A- 10 019 813
- JP-A- 2001 326 118
- US-A- 5 371 464
- US-A- 5 600 245
- US-A1- 2002 030 491
- US-A1- 2005 092 395
- US-B1- 6 563 315
- ZION B ET AL: "Detection of pits in olives under motion by nuclear magnetic resonance" JOURNAL OF THE SCIENCE OF FOOD AND AGRICULTURE, vol. 75, no. 4, December 1997 (1997-12), pages 496-502, XP002400979 ISSN: 0022-5142
- PATENT ABSTRACTS OF JAPAN vol. 015, no. 234 (P-1215), 14 June 1991 (1991-06-14) -& JP 03 071048 A (SANYO ELECTRIC CO LTD), 26 March 1991 (1991-03-26)

## Description

### FIELD OF THE INVENTION

The present invention generally relates to a portable industrial quality and process control (QPC) system comprising *inter alia* at least one packed array of multi-streamed magnetic resonance devices of substantially no fringing magnetic fields, adapted to analyze adjacent lines of objects optionally *in situ* simultaneously and a method thereof.

### BACKGROUND OF THE INVENTION

Electromagnetic based instruments for measuring properties of matter or identifying its composition are well known. Magnetic resonance spectroscopy is one of the principal measuring techniques used to obtain physical, chemical and structural information about a molecule.

A nuclear magnetic resonance imaging system produces an image of a sample which is based upon its molecular structure. The sample is subjected to a polarizing magnetic field which has the effect of aligning the spins of all the atomic nuclei of the sample. Radio waves at a frequency close to the Larmor frequency of the nuclei are then used to excite the nuclei such that their magnetic alignment is reversed. Once the excitation is removed the nuclei return to their original state by emitting characteristic radio signals. It is these radio signals that can be used to image the sample.

The exact Larmor frequency is dependent upon the precise magnetic field. By creating a magnetic field gradient within the sample cavity the source of these signals can be located such that an overall image of the sample can be constructed.

The efficiency of this process depends upon the consistency of the magnetic field strength within the sample cavity. This field is typically controlled to within 5 parts per million. The extent of the uniformity of the magnetic field determines the accuracy with which the Larmor frequency can be measured. This allows for the resolution of smaller chemical shifts.

Uniformity of magnetic fields to less than 5ppm is very difficult to achieve over a large volume. A targeted magnetic resonance device, however, images a much smaller region of interest, over which it becomes easier to achieve very high uniformity such that very small chemical shifts can be resolved.

In order to overcome fluctuations in the permanent magnetic field produced by a surrounding magnetic circuit, a variety of shimming methods may be used, such as the inclusion of ferromagnetic material of specific shapes at specific locations for example as described in patent no. GB 2,378,763 or the use of oddly shaped shimming coils whose magnetic fields can be adjusted by controlling the current passing through them.

In order to superimpose a magnetic field gradient onto the uniform magnetic field in the sample cavity, additional gradient coils are used. The higher the magnetic gradient that can be produced by the gradient coils, the higher the resolution of the image acquired, however in order for the gradient to cover the whole sample cavity requires a large coil.

The larger the coils the greater the power required to generate a given magnetic gradient. In addition, large coils have high inductance which reduces the slew rate which can be achieved with them.

When a live sample, such as human patient is subject to a changing magnetic field, nerve stimulation can result from a induced potential within the neurones leading to undesired physiological effects. A magnetic resonance device which exposes only the field of interest to a changing magnetic field would limit the scope of such effects as the region not being imaged is not subject to any stimulating field.

There is thus a long felt need in the art for a cost effective multilayered magnetic resonance device and method of performing high resolution imaging over a portion of its total field of view. More particularly to a magnetic resonance device adapted for the inclusion of a human head which produces high resolution images over the area of interest without exposing the whole sample to high magnetic field gradients.

Moreover, in order to introduce a plurality of samples into a single magnetic resonance device a conveying mechanism is necessary. Such a mechanism is often the source of inefficiency in the system where the conveying mechanism passes through the region of uniform magnetic field as the region occupied by the conveying mechanism is not available for the introduction of a sample to be measured. A conveying mechanism is therefore necessary which introduces the sample into the region of uniform magnetic field without itself occupying said region.

In order to measure a fluid sample a measurement pipe is provided around which a gradient coil is wound. It is thus possible to perform magnetic resonance measurements on any sample passing through said pipe. In order to measure a plurality of different fluids it is necessary to provide a manifold comprising a system of feeder pipes each connected via a valve to the measurement pipe. Each separated fluid is then introduced into the measurement pipe individually. This set up is problematic as passing many fluids through the same measurement pipe is time consuming especially where the need for cleaning the pipe between samples is taken into consideration. A system providing many measurement pipes which can be operated simultaneously would be of significant benefit particularly in industrial settings. There is thus a long felt need in the art for a cost effective multi-streamed magnetic resonance device and method thereby of simultaneously measuring a plurality of samples.

Furthermore, most of the commercially available magnetic resonance devices are non-portable. They generate a powerful external magnetic field while analyzing items in their inner volume. Such undesired fringing magnetic fields eliminate the option of installing magnetic resonance device side-by-side.

Nowadays, significantly reduced magnetic forces are obtained outside a few magnetic resonance devices, i.e., ASPeCT TM devices, claimed to achieve up to two Tesla magnetic field with uniformity suitable for sub-ppm magnetic resonance analysis and over 400 mm usable air gap between the pole pieces.

Methods and apparatus for analyzing objects by magnetic resonance technique are various and well-known but currently available non-portable devices cannot determine the properties of said objects *in situ* and provide an analyze of a plurality of adjacent lines of objects simultaneously. U.S. Pat. Appl. 2002/0030491 discloses a means for providing multiple RF coils and multiple gradient coils for performing simultaneous MRI measurements on multiple samples. The apparatus disclosed in this application encloses all of the samples in a single homogeneous magnetic field and provides a single simultaneous excitation pulse for all of the samples. No provision for independent measurements of different samples, or for independent magnetic fields for different samples, is made. European Pat. 1253433 discloses a probe suitable for use in magnetic resonance based spectroscopy. This probe is of an extended toroidal design. Simultaneous measurements on multiple samples are not enabled by the design therein disclosed, however.

One typical use of magnetic resonance techniques is for agricultural products, in order to detect non-destructively any abnormalities in the goods being tested. PCT Pat. Appl. No. 02/059586 discloses an apparatus and method for analyzing and improving agricultural products. In this application, however, the examination of the sample does *not* proceed *in situ.* Zion et al. ("Detection of Pit in Olives Under Motion by Nuclear Magnetic Resonance," J. Sci. Food Agric. 1997, 75, 496 - 502) have demonstrated that MRI can be used to distinguish, with >95% accuracy, between pitted and unpitted olives traveling on a conveyor belt passing through a 2 T NMR magnet and a 150 mm imaging coil. This method is not suitable for actual agricultural use, however. Since a superconducting magnet was used, transporting the instrument to the factory or orchard (or from one location to another, assuming that the owners of an olive orchard or the factory in which they are pitted or canned would be willing to invest in a high-field NMR system) is quite simply out of the question. In addition, the relatively large fringing fields associated with superconducting magnets that limit the proximity of one such system to another, not to mention the high costs associated with purchase and maintenance of a high-field NMR system, eliminate any possibility that such a system could reasonably be expected to be used for simultaneous measurements of multiple samples. In order to provide suitable quality control for agricultural goods and to determine the right time for picking vegetables or fruit, a portable magnetic resonance quality and process control device is thus necessary.

Another typical use of the magnetic resonance techniques is for spectroscopy on patients, in order to detect abnormalities in living cell tissue.

US Pat No 2005204473 discloses an imaging tomography apparatus, such as an x-ray computed tomography apparatus or a magnetic resonance tomography apparatus, has a patient bed that can be driven into a tunnel-shaped or annular data acquisition device. To increase comfort for the patient and accessibility by medical personnel, the patient bed has a pivotable backrest connected to a seat.

Trauma patients require specialized care, including stabilization, surgery and often blood transfusion. Many deaths which could have been prevented by appropriate care occur in relatively short time after injury at the site of injury. Emergency medical technicians, paramedics, and sometimes veterinary surgeons, use stabilization techniques to improve the chances of a trauma patient surviving the ambulance trip to the hospital. The neck and back are secured before moving the immobilized patients to ensure that the injured person is not disabled by unnecessary movement of the spine.

In order to diagnose the damage caused by the injury, the medical team has to transfer the patients to hospital's magnetic resonance rooms, and proceed to a magnetic resonance spectroscopy, where the devices are fixed in order to perform. But, during the pre-hospitalization, intra-hospitalization and post-hospitalization investigations, all superfluous movement is unnecessary and potentially harmful. This is why a portable magnetic resonance quality and process control device to diagnose patient *in situ* is thus a long felt need.

Methods and apparatus for analyzing objects by magnetic resonance technique are various and well-known but currently available non-portable devices cannot determine the properties of said objects *in situ.*

### SUMMARY OF THE INVENTION

It is therefore one object of the present invention to present a portable industrial quality and process control (QPC) system as defined in claim 1.

Another object of the present invention is to disclose a cost effective and industrially oriented method as defined in claim 7.

### BRIEF DESCRIPTION OF THE INVENTION

In order to understand the invention and to see how it may be implemented in practice, few preferred embodiments will now be described, by way of non-limiting example only, with reference to the accompanying drawing, in which

figure 1 presents a packed array of magnetic resonance devices according to one embodiment of the present invention, adapted for analyzing adjacent lines of objects simultaneously; and,

figures 2A-2C schematically illustrate various stacks of magnetic resonance devices according to yet another embodiment of the present invention, wherein in figure 2A i equals 2, x = 2, y = 1 and *z* = 0; in figure 2B 2A *i* equals 6, *x* = 3, *y* = 2 and *z*= 0; and in figure 2C i equals 24, x = 4, y=3 and z=2;

figure 3A schematically represents a cross section of a magnetic resonance device according to one embodiment of the current invention;

figure 3b schematically represents a top view of the magnetic resonance device showing the positions of the global and local gradient coils (304) according to the current invention;

figure 4a schematically represents a cross section through the magnetic resonance device showing the magnetic field in the sample cavity produced by the closed magnetic circuit magnets, according to the current invention;

figure 4b schematically represents a top view of the magnetic resonance device showing the magnetic field in the sample cavity produced by the closed magnetic circuit magnets, according to the current invention;

figure 5 schematically represents the magnetic field gradient throughout the sample cavity produced by the global gradient coil, according to the current invention;

figure 6 schematically represents the magnetic field gradient, in the field of interest, produced by a local gradient coil, according to the current invention;

figure 7 schematically represents the magnetic field gradient, produced by a local gradient coil, passing through the head of a patient which has been introduced into the sample cavity, according to an example useful for understanding the current invention;

figure 8 schematically presents schematically presenting a stratificated feeding system in a magnetic resonance device (1000) according to one embodiment of the present invention;

figures 9A to 9E illustrate schematic out of scale top views of the cavity inside a magnetic resonance device 1000;

figure 10 schematically represents one embodiment of the current invention wherein the pole pieces are situated to the sides of the conveyor belt which lies wholly outside the region of uniform magnetic field;

figure 11 schematically represents another embodiment of the current invention wherein two orthogonal layers of parallel pipes pass through the region of uniform magnetic field;

figure 12 schematically represents a single fluid imaging unit showing the pipe, gradient coil and direction of fluid flow; and,

figure 13 schematically presents a diagram of a portable quality and process control device useful forunderstanding the current invention.

### DETAILED DESCRIPTION OF PREFERRED EMBODIMENTS

The following description is provided, alongside all chapters of the present invention, to enable any person skilled in the art to make use of said invention and sets forth the best modes contemplated by the inventor of carrying out this invention. Various modifications, however, will remain apparent to those skilled in the art, since the generic principles of the present invention have been defined specifically to provide a portable industrial quality and process control (QPC) system as defined in claim 1 and a method as defined in claim 7.

The term **'magnetic resonance device'** applies hereinafter to a device such as an NMR, ESR, NQR or MRI device, adapted to measure the radio signals emitted from the nuclei of the atoms within a sample when said nuclei are excited by electromagnetic radiation.

The term **'packed array'** refers hereinafter to an array of two or more magnetic resonance devices of substantially no fringing magnetic fields, wherein the distance between said devices is respectively small, such that a plurality of feeding lines are directed to said array, and a rapid analysis of a mass (i.e., industrial scale) of objects is provided simultaneously.

The term' **QPC'** refers hereinafter to a magnetic resonance device adapted to analyze the properties, compositions or shape of objects *in situ,* as well as processes and reactions, wherein the terms **'analysis'** and/or **'QPC'** are denoted hereinafter to any detection, analysis, control, measurement, study, observation or study of a given matter or process by a means of a magnetic resonance device.

The term **'field of view'** applies hereinafter to a volume over which a magnetic gradient is applied.

The term **'resolution'** applies hereinafter to a device's ability to distinguish between two elements such as the magnetic resonance device's ability to distinguish the distance between two signals.

The term **'multilayered cage'** applies hereinafter to an envelope surrounding a cavity comprising a plurality elements arranged in layers.

The term **'sample cavity'** applies hereinafter to a cavity within a containing envelope within which a sample is introduced.

The term **'magnetic circuit'** applies hereinafter to the path of magnetic flux from north to south magnetic poles.

The term **'shimming mechanism'** applies hereinafter to any mechanism for correcting the inhomogeneities of a magnetic field due to imperfections in the magnet or the presence of external ferromagnetic objects. A shimming mechanism may include, inter alia, passive shimming elements, active shimming elements, feedback controlled shimming, CPU controlled shimming, superconducting shimming elements.

The term **'shim coils'** or **"active shimming elements"** applies hereinafter to coils positioned around the magnets in order to correct any inhomogeneities of the magnetic field.

The term **'passive shimming elements'** applies hereinafter to pieces of ferromagnetic material positioned around the magnets in order to correct inhomogeneities of the magnetic field.

The term **'gradient coil'** applies hereinafter to a coil used to create a magnetic gradient over at least a portion of the sample cavity.

The term **'tracks'** applies hereinafter to any means of moving one element relative to another, such as rails upon which a gradient coil slides relative to the sample cavity.

The term **'slew rate'** applies hereinafter to the rate of increase or decrease of a magnetic gradient from zero to its maximum absolute value.

The term **'sample imaging units'** applies hereinafter to a device adapted to provide a means of measuring the magnetic resonance of a sample within a uniform magnetic field.

The term **'fluid imaging units'** applies hereinafter to a device adapted to provide a means of measuring the magnetic resonance of a fluid sample within a uniform magnetic field.

The term **'switching rate'** applies hereinafter to the number of separated devices which are activated in a given time period.

The term **'pole piece'** applies hereinafter to an element of high permeability material used to shape the uniformity of the magnetic flux from a permanent magnet. In one such example a pole piece is constructed from small granules of ferromagnetic material, the diameter of each granule is of the order of one micron. Said granules are embedded within a plastic coating which serves to strengthen the granules and prevent distortion of their shapes. The material is cut into small cubes which are stuck together with non-conducting glue and with spacers between the granules. Such a construction prevents the formation of large eddy currents within the pole piece, thereby increasing the efficiency of the magnet.

The term **'side wall magnets'** applies hereinafter to permanent magnets arranged around the sides of pole pieces that maintain the uniformity of the magnetic field from the permanent magnet.

The term **'plurality'** applies hereinafter to any integer greater than or equal to one.

The term **'portable'** applies hereinafter to any hand-held or wearable devices. Said device can be carried or worn by the human body on a belt or in a pocket.

The term 'mobile' applies hereinafter to any vehicular, aircraft or ship-based systems, wireless systems in trucks, vans, cars, boats, or motorcycles.

The term **'platform'** refers hereinafter to any mobile vehicle, aircraft or ship-based systems. For example, the term refers also to tractors, caterpillars, draglines, loaders, especially wheel loaders, shovels, cranes, powder lift trucks.

The term **'citrus'** refers in the present invention to any clementines, mandarin, oranges, grapefruit, pomelo, rangpur, sweet orange, lime, citron tangerine or lemon. Specifically and in a non-limiting manner, the term citrus further refers to amanatsu, bergamot orange, bitter orange (seville orange),calamondin (calamansi), golden lime - hybrid between the genus citrus and the genus fortunella, dancy, ichang lemon, kaffir lime, key lime, kumquat - in the related genus fortunella, not citrus; forms hybrids with citrus, limequat, mandarin lime, mandarin orange, meyer lemon, mikan, minneola, orangelo (chironja), orangequat, persian lime (Tahiti lime), rough lemon, satsuma, shekwasha (Taiwan tangerine), sweetie, tachibana orange, tangelo, tangor ugliy; yuzu etc.

The term **'drupe'** refers in the present invention to any peach, pear, plum or apricot. In botany, a drupe is a type of fruit in which an outer fleshy part (exocarp or skin and mesocarp or flesh) surrounds a shell (the pit or stone) of hardened endocarp with a seed inside. These fruits develop from a single carpel, and mostly from flowers with superior ovaries. The definitive characteristic of a drupe is that the hard, lignified stone (or pit) derives from the ovary wall of the flower. Specifically and in a non-limiting manner, the term drupe further refers to coffee, jujube , mango, olive, all members of the genus *Prunus,* including the almond (in which the mesocarp is somewhat leathery), apricot, cherry, peach, nectarine, plum etc.

The term **'climacteric fruit'** refers in the present invention to any fruit that continues to ripen after harvest. Fruits and vegetables can be classified as climacteric or non-climacteric. Climacteric fruit continues to ripen after harvest, whereas non-climacteric does not. Ripening is a process that includes development of color, flavor and texture (softening). This means that the ripening process continues after abscission (when the fruit drops).

The term **'ripening'** refers in the present invention to a process in fruit that causes them to become more edible. As fruits ripen, they get sweeter, less acidic, less green and softer.

The system comprises *inter alia* at least one packed array of *i* magnetic resonance devices of substantially no fringing magnetic fields, adapted to analyze up to *i* lines of objects simultaneously, wherein *i* is an integer number higher or equal 2.

It is in the scope of the present invention wherein said packed array is a stack comprising a plurality of i magnetic resonance devices, characterized by the dimensions of *x*, *y* and *z* magnetic resonance device; and further wherein i is an integer number higher or equal 2, and *x*, *y* and *z* are integer numbers higher or equal 0, such that in case those values higher or equal 1, *x*y*z* equals *i*. The shape of at least a portion of the stack is preferably polygonal, circular or any combination thereof.

It is also in the scope of the present invention wherein at least a portion of the objects are fed into the magnetic resonance devices by means of a conveyor belt or the like, by means of tunnels, conduits or pipes or any combination thereof. The system is further adapted to operate either continuously or in a batch wise manner.

It is also in the scope of the present invention wherein the magnets of the magnetic resonance devices are passively shielded and/or actively shielded by means of an RF and/or magnetic shielding.

The QPC system defined above is preferably comprising additional computerized means, adapted for time sharing of at least one of the group consisting in a non-limiting manner gradient power supplying; RF transmitting and/or amplifying; RF receiving; digital signal processing or any combination thereof.

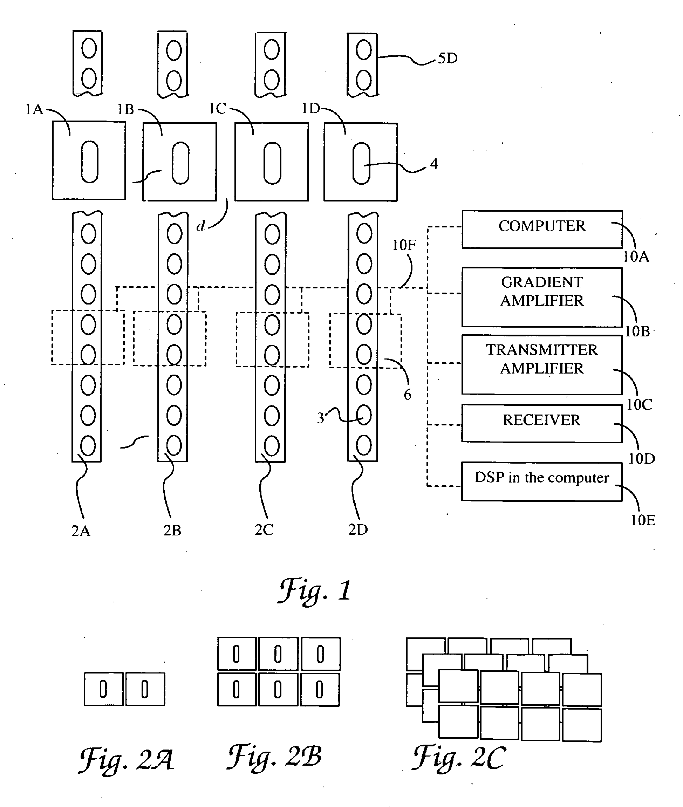

Reference is made now to figure 1, schematically presenting an industrial QPC system, comprising *inter alia* at least one array of magnetic resonance devices of substantially no fringing magnetic fields (1A-1D). Here the magnetic resonance devices are arranged in parallel such that the distance (*d*) between devices (1A-1D) is short and determined mainly by the feeding requirements, e.g., the optimum distance between the various feeding conveyor belts (e.g., 2B and 2C).

According to this example and in a non-limiting manner, said four magnetic resonance devices (1A-1D) are fed by four parallel conveyor belts (2A-2D), each conveyor transports into one of the magnetic resonance devices a continuous, segmented or pulsed series of objects (3) to be examined.

Various models are possible, such as a sorting facility adapted for sorting incubator's avian eggs, e.g., divide lines of eggs to gender of the embryo; a system adapted for selective elimination of fertilized eggs from product line, evacuating eggs characterized with improper size or condition, or provided with predetermined physiological condition..

Another example is sorting fruits and other agricultural products and raw materials, and especially utilizing in citrus packing house to be QPC for the inspection of presence of seeds, presence of a hollow core inside the fruit, defining over ripped stages, mold damages, freeze damages sugar level, water level and pH etc. This example is further provided useful for other feeding systems, such as wherein the objects are in a liquid state, e.g., QPC of oil refinery industry; wherein multiple pipes comprising flowing oil in its various refining process is enforce to flow into the magnetic resonance devices for analysis. According to this embodiment of the present invention, each feeding line (e.g., 2D) is entering the magnetic resonance device (ID, frontal view) *via* at least one inflow aperture (4), and exiting (5D) said magnetic resonance device *via* at least one outflow aperture (not shown). The QPC is provided either continuously or in a batch wise manner, e.g., by stopping the line to a predetermined short period of times before magnetic resonance analysis the objects.

It is hence according to one aspect of the present invention wherein the QPC as defined above is adapted for sorting incubator's avian eggs, and especially sorting the gender of embryo; selectively eliminating fertilized eggs from product line; or evacuating eggs characterized with improper size or physiological condition or any combination thereof.

It is hence according to another aspect of the present invention wherein the QPC as defined above is adapted for sorting fruits and other agricultural products and raw materials, and especially for utilizing in citrus packing house to inspect presence of seeds, locating a hollow core inside the fruit, defining over ripped stages, scanning mold damages, determining freeze damages sugar level, evaluating water level or determining fruit's acidity or any combination thereof.

It is according to yet another embodiment of the present invention wherein the said magnetic resonance device enabled QPC further comprises computerized means (10A), enabling *inter alia* time sharing of gradient power supply (10B), time sharing of RF transmitter and/or amplifier (10C), time sharing of RF receiver (10D), time sharing of digital signal processing (10E). Said QPC is preferably yet not exclusively provided by window (6, top view). It is acknowledged in this respect that any combination of time sharing as defined above with one, few or all magnetic resonance devices is possible.

Reference is made now to figures 2A, 2B and 2C illustrating in a non-limiting manner various stacks, wherein 2A and 2B describes a front view of a polygonal stack, and figure 2C presents a lateral view of the same.

It is further in the scope of the present invention wherein the analyzed objects are either solid or liquid matter; and especially wherein the analyzed objects are selected from agricultural raw materials or products, cosmetics, chemicals, powders, gases, enveloped items, medicaments, industrial matters, metal ware or any other continuous or discrete members or combination of solid, liquid and gas.

It is according to one embodiment of the current invention to present a magnetic resonance device for imaging over a large field of view and subsequently imaging over a portion thereof at higher resolution. This device comprises a multilayered cage containing the sample cavity into which a sample is introduced and imaged. The cage comprises a closed magnetic circuit constructed from strong permanent magnets, and where necessary for the maintenance of a uniform magnetic field, a shimming mechanism selected from an array of shim coils, passive shimming elements or any combination thereof. The cage additionally comprises a global gradient coil and an array of local gradient coils. Said device provides images selected from low-resolution images over a large field of view, high-resolution images over a smaller field of view, or any combination thereof.

It is according to another embodiment of the current invention to present a magnetic resonance device wherein adjacent local gradient coils overlap such that each portion of the sample cavity is situated within the field of view of at least one local gradient coil.

It is according to a further embodiment of the current invention to present a magnetic resonance device additionally comprising tracks upon which at least one local gradient coil is manoeuvred such that its field of view covers any portion of the sample cavity.

It is according to yet another embodiment of the current invention to present a magnetic resonance device, adapted such that the either one large sample or a plurality of smaller samples are introduced into the sample cavity and any section of total sample is imaged therein.

It is according to yet another embodiment of the current invention to present a magnetic resonance device for the imaging of a large sample extending over a plurality of local gradient coils, wherein the local gradient coils are characterized by a fast slew rate such that a plurality of images are acquired sequentially from a plurality of local gradient coils.

It is according to the current invention to present a magnetic resonance device wherein the closed magnetic circuit is characterized by two pole pieces and an array of side wall magnets, which lock the magnetic flux within the magnet structure and sample cavity.

It is according to the current invention to present a magnetic resonance device wherein the field of view of the global gradient coil covers the whole volume of the sample cavity.

It is according to a further embodiment of the current invention to present a magnetic resonance device wherein the shimming mechanism comprises an array of passive shim elements.

It is according to a further embodiment of the current invention to present a magnetic resonance device wherein the shimming mechanism comprises an array of tuneable shim coils, which can be tuned to create a uniform magnetic field over the field of view of at least one local gradient coil such that a high-resolution nuclear magnetic spectrum of a sample situated within this field of view is obtained.

It is according to a further embodiment of the current invention to present a magnetic resonance device wherein the shimming mechanism comprises an array of tuneable shim coils, which are tuned to create a uniform magnetic field over a limited region of the whole sample.

It is according to another embodiment of the current invention to present a magnetic resonance device wherein the array of sidewall magnets is bent such that the magnetic field remains uniform within the volume adapted to accommodate the head and shoulders.

It is according to the current invention to present in a multi-layered portable QPC, a multi-streamed magnetic resonance device comprising the following elements. A cage comprising a closed magnetic circuit constructed from strong permanent magnets and an optional shimming mechanism selected from an array of active shim coils, passive shimming elements or any combination thereof, a contained cavity within which the magnetic field strength is approximately uniform and a means, such as a plurality of conveyor belts, pipes or any other transportation means by which a plurality of samples are introduced into the region of uniform magnetic field. This device is allows for magnetic resonance measurements to be made on a plurality of samples within the region of the said uniform magnetic field.

It is according to the current invention to present in a multi-layered portable QPC a multi-streamed magnetic resonance device wherein the closed magnetic circuit is characterized by two pole pieces and an array of side wall magnets, which lock the magnetic flux within the magnet structure and sample cavity..

It is according to a further embodiment of the current invention to present in a multi-layered portable QPC a multi-streamed magnetic resonance device additionally comprising a plurality of sample imaging units. Each sample imaging unit comprises a conveyor belt which transports a sample into the region of uniform magnetic field, a gradient coil around said conveyor belt and a magnetic resonance measurement probe. In addition a means, such as a CPU, allows the gradient coils of each sample imaging unit to be activated in rapid succession such that magnetic resonance measurements are made on a plurality of discrete samples within the region of uniform magnetic field.

It is according to a further embodiment of the current invention to present in a multi-layered portable QPC a multi-streamed magnetic resonance device wherein a plurality of sample imaging units are situated parallel to each other such that a plurality of samples are conveyed into the region of uniform magnetic field simultaneously along a plurality of streams.

It is according to another embodiment of the current invention to present in a multi-layered portable QPC a multi-streamed magnetic resonance device wherein the pole-pieces of the magnetic circuit are orientated horizontally to the sides of the contained cavity such that at least one conveyor belt is situated outside the region of uniform magnetic field whilst conveying the sample into the region of uniform magnetic field.

It is according to a further embodiment of the current invention to present in a multi-layered portable QPC a multi-streamed magnetic resonance device wherein the pole-pieces of the magnetic circuit are orientated horizontally to the sides of the contained cavity such that at least one conveyor belt is situated beneath the region of uniform magnetic field whilst conveying the sample into the region of uniform magnetic field.

It is according to another embodiment of the current invention to present in a multi-layered portable QPC a multi-streamed magnetic resonance device wherein the pole-pieces of the magnetic circuit are orientated horizontally to the sides of the contained cavity such that at least one conveyor belt is situated above the region of uniform magnetic field whilst conveying the sample into the region of uniform magnetic field.

It is according to a further embodiment of the current invention to present in a multi-layered portable QPC a multi-streamed magnetic resonance device adapted for the measurement of fluid samples comprising a plurality of fluid imaging units. Each fluid imaging unit comprises a pipe within which a fluid sample flows through the region of uniform magnetic field, a gradient coil around said pipe and a magnetic resonance measurement probe. In addition a means, such as a CPU, allows the gradient coils of each sample imaging unit to be activated in rapid succession such that magnetic resonance measurements are made on a plurality of discrete fluid samples within the region of uniform magnetic field.

It is according to another embodiment of the current invention to present in a multi-layered portable QPC a multi-streamed magnetic resonance device wherein at least two fluid imaging units are orientated orthogonally such that the gradient coils of both units can be activated simultaneously with no interference.

It is according to a further embodiment of the current invention to present in a multi-layered portable QPC a multi-streamed magnetic resonance device wherein at least two fluid imaging units are orientated near orthogonally such that the switching time between activation of the gradient coils of each of the units can be activated almost simultaneously with a small switching time between them.

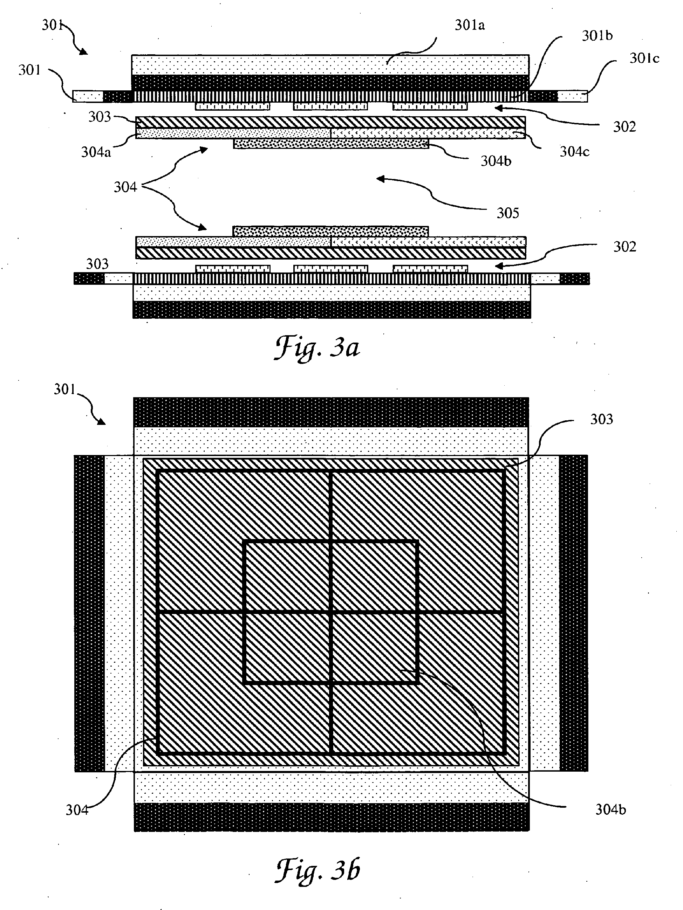

Reference is made now to figure 3a, schematically presenting a cross section of a targeted magnetic resonance device according to one embodiment of the current invention. A closed magnetic circuit, 301, comprises a large permanent magnet, 301a, a pole piece, 301b and an array of side wall magnets, 301c, surrounding a central sample cavity, 305. A shimming mechanism, 302, is used to maintain uniform magnetic field within the cavity. A global gradient coil, 303, extends along the length of the sample cavity. An array of local gradient coils, 304, are positioned at intervals along the length of the cavity and overlap such that any volume section within the sample cavity is within the field of at least one of the local gradient coils.

Reference is made now to figure 3b, schematically presenting a top view of the magnetic resonance device according to one embodiment of the current invention. This diagram shows the positions of the global gradient coil, 303, and the local gradient coils, 304, the central local gradient coil, 304b, overlaps with the other local gradient coils. It is acknowledged that the local gradient coils, 304, represented in this figure as squares, may take any shape such as circular, cylindrical or any regular or irregular geometry.

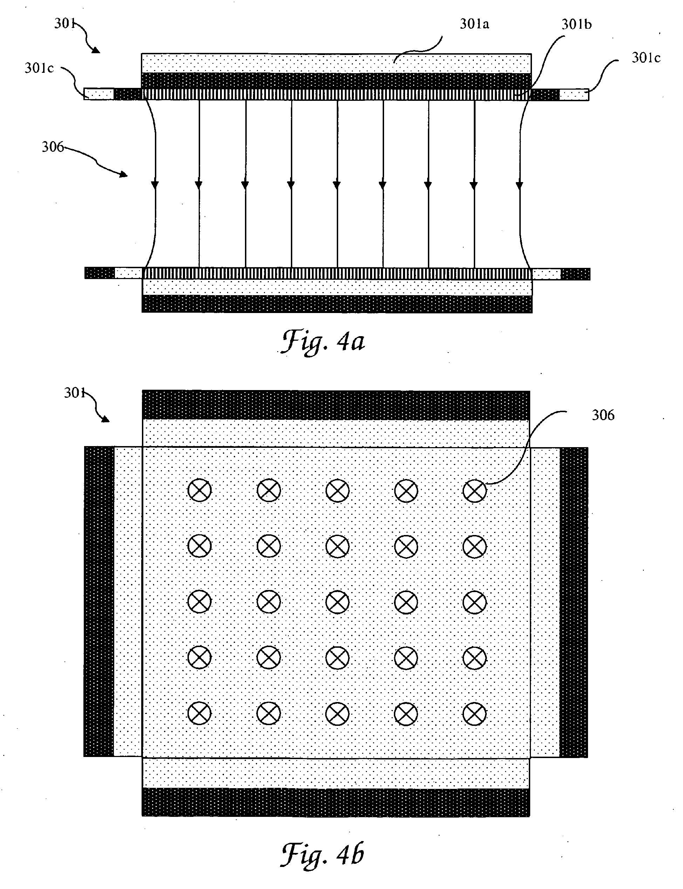

Reference is made now to figure 4a, schematically representing a cross section through the magnetic resonance device showing magnetic field lines, 306, in the sample cavity produced by the closed magnetic circuit, 301, comprising a large permanent magnet, 301a, a pole piece, 301b and an array of side wall magnets, 301c, according to the current invention.

Reference is made now to figure 4b, schematically representing a top view of the magnetic resonance device showing the magnetic field, 306, in the sample cavity produced by the closed magnetic circuit magnets, 301, according to the current invention.

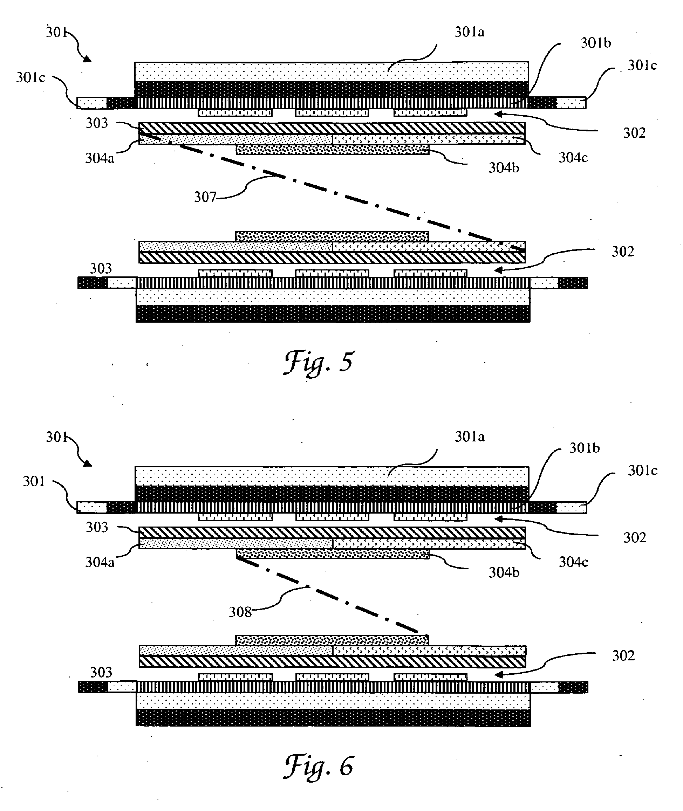

Reference is made now to figure 5, schematically representing the magnetic field gradient, 307, throughout the sample cavity of the magnetic resonance device, produced by the global gradient coil, 303, according to the current invention.

Reference is made now to figure 6, schematically representing the magnetic field, 308, within the field of interest in one volume section of the sample cavity, produced by one local gradient coil, 304b, according to the current invention.

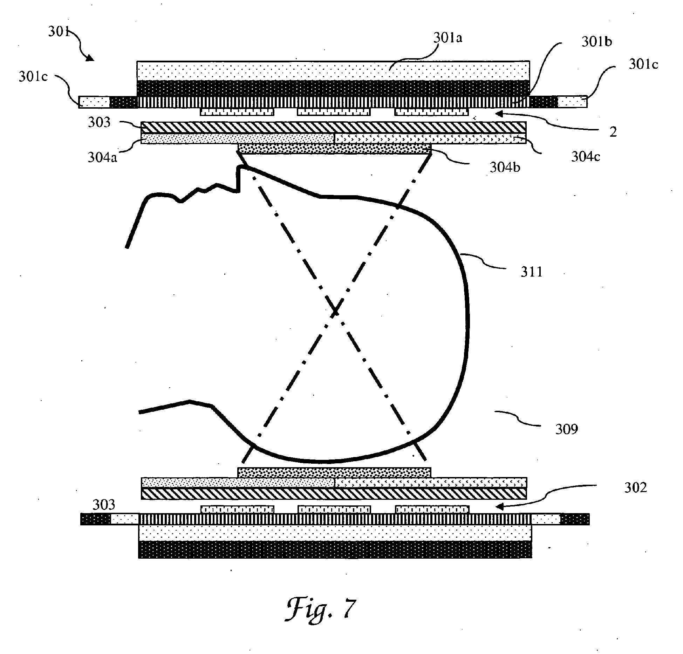

Reference is made now to figure 7, schematically representing the magnetic field gradient, 309, produced by one local gradient coil, 304c, passing through the head of a patient, 311, which has been introduced into the sample cavity, according to an example useful for understanding the current invention. The high magnetic field is directed only over the field of interest reducing exposure and nerve stimulation elsewhere in the brain of the patient.

In a magnetic resonance device, the present invention discloses an improved feeding system comprising at least two adjacent feeding streams carrying a plurality of objects to be detected or analyzed simultaneously or in any predetermined sequence. More specifically and according to one embodiment of the present invention, the said stratificated magnetic resonance device comprising at least two feeding systems as defined above said at least two feeding systems are relatively oriented in one plane (2D). Additionally or alternatively, a stratificated magnetic resonance device comprising at least two feeding systems as defined above is disclosed; said at least two feeding systems are oriented in a plurality of planes thus being in a 3D orientation. Said streams are possibly yet not exclusively in a parallel orientation, perpendicular orientation or a combination thereof.

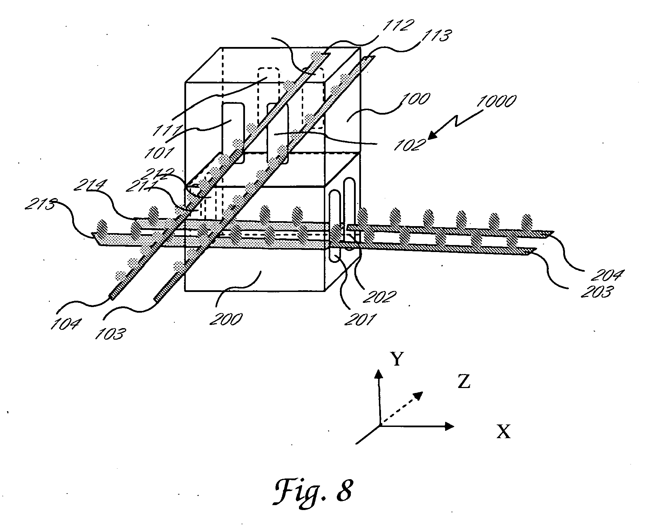

Reference is made now to figure 8, schematically presenting a stratificated feeding system in a magnetic resonance device (1000) according to one embodiment of the present invention. Here for example and in a non-limiting manner, magnetic resonance device comprising two adjacent feeding systems 100 and 200 being in a respectively perpendicular orientation such that lines 103 and 104 are directed along the main Z axis while line 203 and 204 are simultaneously directed along the main X axis of the device. Lines 203 and 204, as lines 104 and 103 are illustrated hereby as an example for a plurality of n parallel lines, wherein n is any integer number equal or greater than 1. In this example and only for illustrating the technology in a non-limiting manner, n of both X lines and Z lines equals 2. In one embodiment n is between 2 and 6. In another embodiment n is between 4 to 10. In another embodiment n is significantly greater than 8.

Lower layer 200 comprising thus two feeding lines 203 and 204, adapted to carry objects, here eggs, by a means of two rotating conveyor belts. Said conveyor belts are parallel, such as objects of belt 203 enter portion 200 in magnetic resonance device 1000 via aperture 201 or 211, while objects of belt 204 enter portion 200 in magnetic resonance device 1000 via aperture 202 or 212. Hence, the feeding directions of belts 203 and 204 may be parallel, opposite, and in a case that n is grater than 2, any combination thereof. It is acknowledged in this respect that conveyor belts or their like are selected in a non exclusive manner from a linear shape, curved shaped, zigzag, U shape or a combination thereof. Even though a 2D root is hereby illustrated, a 3D advancing root of the belt is also in the scope of the present invention. Hence for example, a possible U-belt 203 may enter cavity 200 via aperture 201 and exit the same via cavity 202 and vice versa.

In a very similar manner, conveyor belts 103 and 104 are linear and parallel belts carrying objects, e.g., oranges, via apertures 101 and 102, throughout cavity portion 100 of device 1000 to leave via apertures 112 and 113, respectively.

It is further in the scope of the present invention wherein the stratification of magnetic resonance device 1000 is characterized by more than two layers, forming more than two detecting volumes 100 and 200. It is hence another embodiment of the present invention wherein said magnetic resonance device comprises a plurality of m detecting volumes, wherein *m* is any integer number greater or equal 2. In one embodiment m is between 2 and 6. In another embodiment m is between 4 to 10. In another embodiment m is significantly grater than 8.

It is further in the scope of the present invention wherein the objects detected in each conveyor belts or their like is similar to objects detected in adjacent belt. Nevertheless, it is well in the scope of the present invention wherein various objects either in solid, liquid and/or gas phases are simultaneously detected by means of magnetic resonance device 1000. The term simultaneously refers in this respect to an identical detecting effort or time, or a sequence of detection provided in a rapid course of detecting events. Said detections as well as feeding parameters are hence may be subject of processing means adapted to control and coordinate the same.

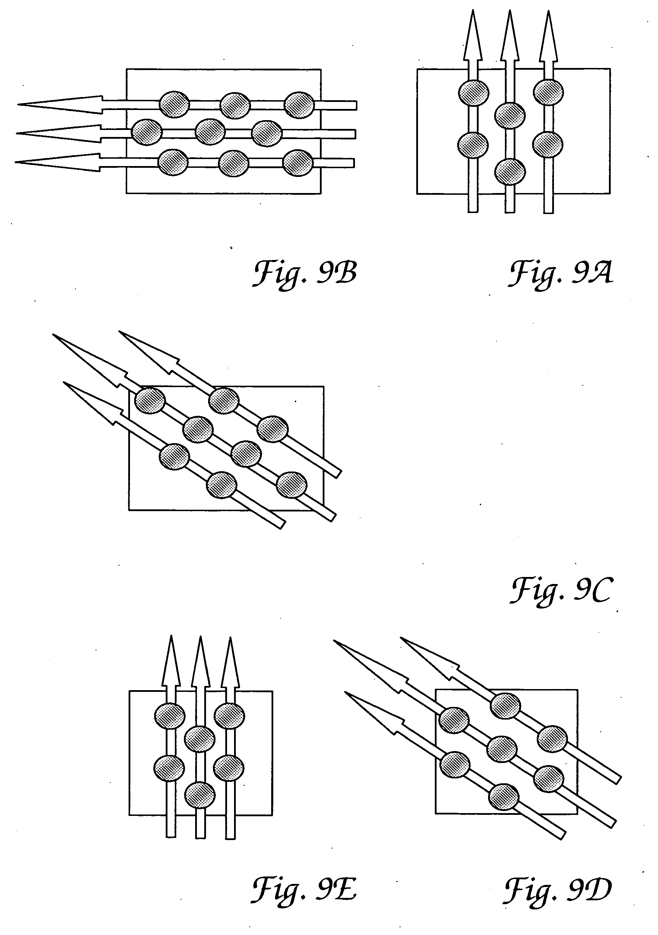

Reference is made now to figures 9A to 9E illustrating a schematic out of scale top view of the cavity inside a magnetic resonance device 1000. Said device comprises one feeding system, two or more adjacent feeding systems or a stratification of the same (e.g., both systems 100 and 200). For the sake of simplicity, a system comprising three parallel feeding lines is always drawn. Fig. 9A shows a rectangled device, comprising nine objects to be detected simultaneously or in a predetermined sequence. The feeding lines are parallel to the main longitudinal axis of the rectangle. Fig. 9B shows the same rectangle system wherein the streams are parallel to the width, comprising six objects to be detected simultaneously or in a predetermined sequence. Fig. 9C shows the same rectangle system wherein the streams are parallel to one main diagonal, comprising eight objects to be detected simultaneously or in a predetermined sequence. In this case most objects are detected in the main longitudinal system (fig. 9A), yet the introduction of samples into the non uniform region of the magnetic field for an extended time provides for the nuclei of the sample to reach a stable orientation before being introduced into the region of uniform magnetic field. Fig. 9D shows a symmetrical cubic device, wherein the three streams are parallel to the main axis X or Y, comprising six objects to be detected simultaneously or in a predetermined sequence. Fig. 9E shows the same symmetrical cubic device, wherein the three streams are parallel to diagonal of the device, comprising seven objects to be detected simultaneously or in a predetermined sequence, i.e., about 15% more objects.

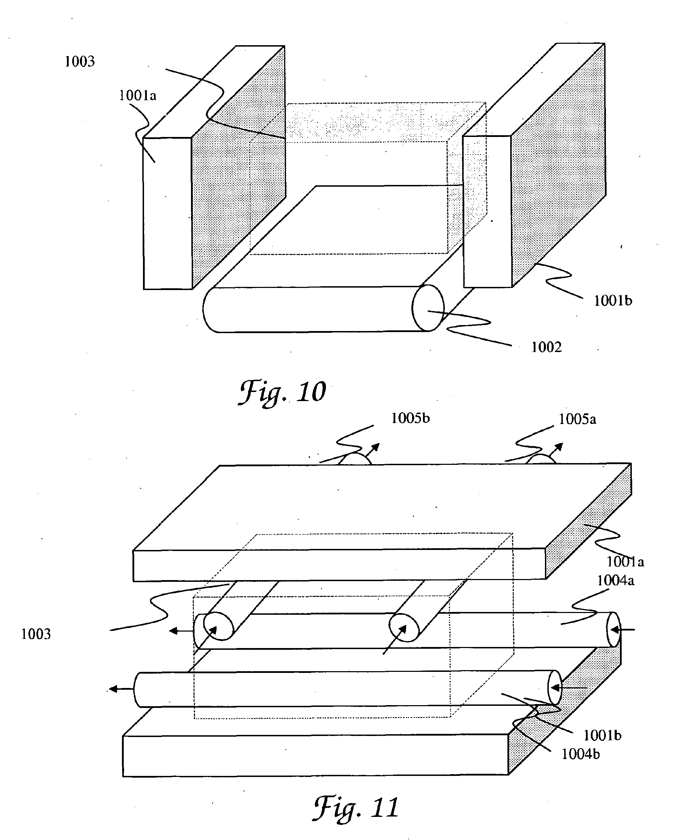

Reference is made now to figure 10, schematically presenting one embodiment of the current invention wherein the pole pieces, 1001a and 1001b, are situated to the sides of the conveyor belt, 1002, which lies wholly outside the region of uniform magnetic field, 1003.

Reference is made now to figure 11, schematically presenting another embodiment of the current invention wherein two orthogonal layers, 1004 and 1005, of parallel pipes pass through the region of uniform magnetic field, 1003. This orientation enables the gradient coil of any pair of orthogonal pipe for example the pair 1004a and 1005a, to be activated simultaneously.

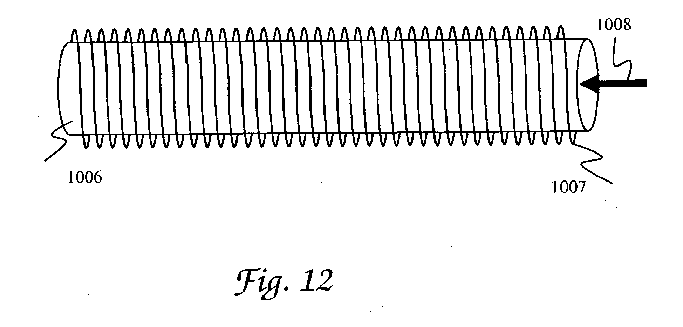

Reference is made now to figure 12, schematically presenting a single fluid imaging unit showing the pipe, 1006, gradient coil, 1007 and direction of fluid flow, 1008.

According to the present invention, said magnetic resonance device is a packed array comprising a plurality of magnetic resonance devices being arranged in either 2D or 3D array.

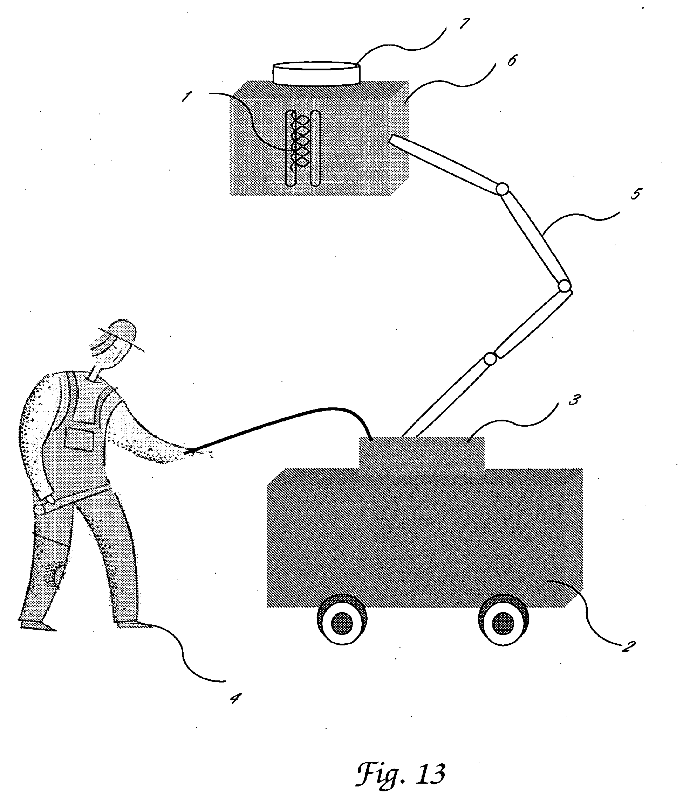

Reference is made now to figure 13, presenting a schematic presenting an agricultural QPC, comprising *inter alia* at least one magnetic resonance device (1). Here for example, the magnetic resonance device is positioned below the tree such that the distance between the device and the fruit is short. According to this useful for understanding the present invention, said magnetic resonance is enclosed a cage (6) fixed on a plurality of adjustable and maneuverable articulated arms (5), connected to a mobile platform (2). A computerized or micro-processor containing controller (3) is activated by an operator (4), operating said magnetic resonance device and activating said mobile platform. A trash trap (7) is intended to capture unwanted material that can disturb the analysis. For example, the said device can check, in a cherry tree, if the ratio between the sugar and the acidity is suitable to pick said cherry.

An example of this present invention is the inspection of a multilayered fruit, such as an orange, to control the presence and the size of the seeds.

According to another embodiment of the present invention, another example is the examination of a multilayered fruit, such as a pear, to control the maturity of the fruit despite of the peel hardness.

Still another example useful for understanding the present invention is the identification and disinfection of insects, by transmitting microwave radiation, e.g., at a frequency of approximately 2.45 GHz.

It is further in the scope of the present invention wherein the portable QPC additionally comprising time sharing of at least one of the group of gradient power supplement; RF transmitter and/or amplifier; RF receiver; digital signal processing means or any combination thereof.

It is further in the scope of the present invention wherein the feeding of analyzed objects is adapted for either solid or liquid matter or gas or any combination thereof.

It is further in the scope of the present invention wherein the analyzed objects are either solid, liquid, gas or a combination thereof; and especially wherein the analyzed objects are selected from agricultural raw materials or products, chemicals, powders, gases, industrial matters, metal ware.

The agricultural raw materials or products thereof are selected in a non-limiting manner from fruits; vegetables; plants; trees; creepers; weeds seeds; cereals from grasses including barley, maize, oats, rice, rye, and wheat; cereals from non-grasses, including buckwheat, amaranth, and quinoa; legumes, including beans, peas, and lentils; nuts, including coconuts, almonds, and pine nuts; oilseeds, including sesame, sunflower, and hemp; root vegetables, including potatoes, cassava, and turnips ;leaf vegetables, including amaranth, spinach, and kale; sea vegetables, including dulse, kombu, and dabberlocks; stem vegetables, including bamboo shoots, nopales, and asparagus; inflorescence vegetables, including globe artichokes, broccoli, and daylilies; fruit vegetables, including pumpkin, okra, and eggplant; herbs and spices.

Still in a non-limiting manner, the agricultural raw materials or products thereof are also selected from dairy products including milk; eggs, including roe and caviar; insects, including honey; meat, including beef, frogs' legs, gaegogi, goat, horse, kangaroo, lamb, mutton, pork, veal, rodents; offal, including blood; poultry, including chicken, turkey, duck, goose, pigeon or dove, ostrich, guinea fowl, pheasant, quail; seafood, including finfish such as salmon and tilapia, and shellfish such as mollusks and crustaceans, snails, game. The analyzed objects are also selected from cosmetics, medicaments, industrial, chemicals raw materials or products thereof.

Another aspect of the present invention is to provide a QPC as defined above, especially adapted to inspect presence of roe in fish and marine invertebrates.

Another aspect of the present invention is to provide a QPC as defined above, especially adapted to evaluate quantity of injected water in meat.

Another aspect of the present invention is to provide a QPC as defined above, especially adapted to determine infection, rotting or presence of free radicals in analyzed objects.

Another aspect of the present invention is to provide a QPC as defined above, especially adapted to determine freezing level of examined product.

Another aspect of the present invention is to provide a QPC as defined above, wherein the analyzed objects are vegetables or fruits.

The fruits are possibly, yet not exclusively selected from the citrus family, or kiwi, pomegranate, drupes, apple, melon, banana, avocado pineapple, mango, tomato, pistachio, persimmon, almond, grapes, blueberries or any other fruit.

It is further in the scope of the present invention wherein the analyzed objects are layered, conglomerated, coated, enveloped, continuous or discrete members.

Various modules are possible, such as a sorting facility especially adapted for sorting fruits and other agricultural products and raw materials, and especially for sorting fruits before or after their picking for the inspection of presence of seeds, the determination of their numbers and sizes; for the detection of the presence of a hollow core, its length, width or volume or any combination thereof inside the fruit; for defining ripe level, mold damage, freeze damage, internal insects damage; for determining dryness; for evaluating water level, water activity, oil level or total liquid in the fruit; for determining number of sections present in the fruit; for determining the deformation or the bruises of the fruit; for determining peel thickness or separation from the fruit section, air cavities ,internal rotting of said fruit; for measuring the textures of the fruit especially hardness or floury texture; for evaluating chemical content as sugar level, fruit's acidity, pH, any magnetic resonance spectroscopy detectable composition or any combination thereof.

It is another embodiment of the present invention to provide a device adapted to identify the presence of insects or other pathogens and to eradicate the same by activating a high frequency radiation. This non-chemical disinfection prevents damage in fruits and is not toxic for the human ingestion. The frequency domain is ranges for example from about 2 to about 4 GHz.

It is acknowledged in this respect that the term insect refers to any microorganism, organisms or pathogens, especially plant or animal pathogens, e.g., organisms selected in a non-limiting manner from viruses, bacteria, fungi, molds, insects, flies, bacteria, nematodes, protozoa, microsporidia, algae, muscae etc.

Another aspect of the present invention is to provide a feed-backed QPC as defined above, being especially adapted to identify the presence of insects or other pathogens and to activate disinfecting means for eradicate the same.

Another aspect of the present invention is to provide a QPC as defined above, particularly adapted to locate parameters inside the fruit selected from a hollow core, length, width or volume or any combination thereof.

Another aspect of the present invention is to provide a QPC as defined above, especially adapted to define a ripe level.

Another aspect of the present invention is to provide a QPC as defined above, especially adapted to scan mold or freeze damages.

Another aspect of the present invention is to provide a QPC as defined above, especially adapted to determine dryness.

Another aspect of the present invention is to provide a QPC as defined above, especially adapted to evaluate water level, water activity (a_{w}), oil level or total liquid in the examined fruit.

Another aspect of the present invention is to provide a QPC as defined above, especially adapted to determine number of sections present in the examined fruit.

Another aspect of the present invention is to provide a QPC as defined above, especially adapted to determine the deformation or the bruises of the examined fruit.

Another aspect of the present invention is to provide a QPC as defined above, especially adapted to determine internal or external insects' damage.

Another aspect of the present invention is to provide a QPC as defined above, especially adapted to determine peel thickness or separation from the fruit section.

Another aspect of the present invention is to provide a QPC as defined above, especially adapted to determine air cavities in analyzed objects.

Another aspect of the present invention is to provide a QPC as defined above, especially adapted to determine internal rotting of examined fruit.

Another aspect of the present invention is to provide a QPC as defined above, especially adapted to analyze chemical content as sugar level, fruit's acidity, pH, any magnetic resonance spectroscopy detectable composition or any combination thereof.

Another aspect of the present invention is to provide a QPC as defined above, especially adapted to measure the textures of the examined fruit and especially hardness or floury texture.

## Claims

1. An industrial quality and process control, QPC, system for magnetic resonance imaging over a large field of view and subsequently magnetic resonance imaging over a portion of said large field of view at higher resolution, wherein
- the system comprises at least one packed array of magnetic resonance devices (1A-1D), adapted to analyze adjacent streams of samples (3) simultaneously; wherein
- the system is portable; wherein
- each of said magnetic resonance devices comprises a multilayered cage comprises:
○ a closed magnetic circuit (301) constructed from strong permanent magnets (301 a) and two pole pieces (301 b) with a sample cavity (305) in-between into which a sample can be introduced and imaged, and an array of side wall magnets (301 c) which lock the magnetic flux within the magnetic circuit and the sample cavity, the magnetic resonance device therefore having substantially no fringing magnetic fields;
○ a global gradient coil (303) for providing low-resolution images over said large field of view, the global gradient coil extending over the length of the sample cavity and having a field of view covering the whole volume of said sample cavity, and
○ an array of local gradient coils (304) for providing high-resolution images over a smaller field of view, the local gradient coils of said array being positioned at intervals along the length of said sample cavity such that any volume section within the sample cavity is within the field of view of at least one of the local gradient coils; and wherein
- the system further comprises a feeding system comprising at least two adjacent feeding streams able to carry a plurality of samples to be detected or analyzed, each feeding stream being arranged to transport into one of the magnetic resonance devices a series of said samples.

2. The QPC system according to claim 1, wherein said magnetic resonance devices of said packed array are disposed in an x by y by z array where x, y and z are integer numbers higher than or equal to 0.

3. The QPC system according to claim 1, wherein adjacent local gradient coils (304) overlap.

4. The QPC system according to claim 1, additionally comprising computerized means (10A) adapted for time sharing of at least one of the group of gradient power supplying (10B); RF transmitting and/or amplifying (10C); RF receiving (10D); digital signal processing (10E) or any combination thereof.

5. The QPC system according to claim 1, wherein, for each magnetic resonance device, the feeding system comprises a conveyor belt which is arranged for transporting a sample into a region of uniform magnetic field in the sample cavity.

6. The QPC system according to claim 6, wherein each magnetic resonance device further comprises a gradient coil around said conveyor belt.

7. A method for performing magnetic resonance imaging over a large field of view and subsequently magnetic resonance imaging over a portion of said large field of view at higher resolution, the method involving in situ analyzing simultaneously multiple adjacent streams of samples (3) by means of a quality and process control, QPC, system by performing measurements on said multiple adjacent streams of samples, **characterized in that** said QPC is an QPC according to any one of claims 1 to 6.

## Patentansprüche

1. Industrielles Qualitäts- und Prozessüberwachungssystem (QPC-System) zur Magnetresonanzbildgebung über ein großes Sichtfeld und danach Magnetresonanzbildgebung über einen Teil des großen Sichtfelds mit höherer Auflösung, wobei
- das System mindestens eine gebündelte Anordnung von Magnetresonanzvorrichtungen (1A-1D) umfasst, die zur gleichzeitigen Analyse benachbarter Ströme von Proben (3) eingerichtet sind; wobei
- das System tragbar ist; wobei
- jede der Magnetresonanzvorrichtungen einen mehrschichtigen Käfig umfasst, umfassend:
• einen geschlossenen Magnetkreis (301), der aus starken Permanentmagneten (301 a) und zwei Polschuhen (301 b) konstruiert ist, mit dazwischen einem Probenhohlraum (305), in den eine Probe eingebracht und der Bildgebung unterzogen werden kann, und eine Anordnung von Seitenwandmagneten (301c), die den magnetischen Fluss innerhalb des Magnetkreises und des Probenhohlraums einschließen, wodurch die Magnetresonanzvorrichtung im Wesentlichen keine magnetischen Streufelder aufweist;
• eine globale Gradientenspule (303) zur Bereitstellung von Bildern mit niedriger Auflösung über besagtes großes Sichtfeld, wobei die globale Gradientenspule sich über die Länge des Probenhohlraums erstreckt und ein Sichtfeld hat, das das gesamte Volumen des Probenhohlraums abdeckt, und
• eine Anordnung örtlicher Gradientenspulen (304) zur Bereitstellung von Bildern mit hoher Auflösung über ein kleineres Sichtfeld, wobei die örtlichen Gradientenspulen besagter Anordnung so in Intervallen entlang der Länge des Probenhohlraums positioniert sind, dass sich gleich welcher Volumenabschnitt innerhalb des Probenhohlraums innerhalb des Sichtfelds mindestens einer der örtlichen Gradientenspulen befindet; und wobei
- das System weiter ein Zufuhrsystem umfasst, das mindestens zwei benachbarte Zufuhrströme umfasst, die fähig sind, eine Vielzahl von Proben, die detektiert oder analysiert werden sollen, zu tragen, wobei jeder Zufuhrstrom dazu angeordnet ist, eine Serie besagter Proben in eine der Magnetresonanzvorrichtungen hinein zu transportieren.

2. QPC-System nach Anspruch 1, wobei die Magnetresonanzvorrichtungen der gebündelten Anordnung in einer x zu y zu z - Anordnung angeordnet sind, wobei x, y und z ganze Zahlen größer als oder gleich 0 sind.

3. QPC-System nach Anspruch 1, wobei benachbarte örtliche Gradientenspulen (304) einander überlappen.

4. QPC-System nach Anspruch 1, zusätzlich computergestützte Mittel (10A) umfassend, die zum Timesharing von mindestens einem aus der Gruppe von Gradienten-Stromzufuhr (10B); HF-Übertragung- und/oder -Verstärkung (10C); HF-Empfang (10D); digitaler Signalverarbeitung (10E) oder gleich welcher Kombination davon eingerichtet sind.

5. QPC-System nach Anspruch 1, wobei für jede Magnetresonanzvorrichtung das Zufuhrsystem ein Förderband umfasst, das zum Transportieren einer Probe in einen Bereich einheitlichen Magnetfelds in dem Probenhohlraum angeordnet ist.

6. QPC-System nach Anspruch 6, wobei jede Magnetresonanzvorrichtung weiter eine Gradientenspule um das Förderband herum umfasst.

7. Verfahren zur Durchführung von Magnetresonanzbildgebung über ein großes Sichtfeld und danach Magnetresonanzbildgebung über einen Teil des großen Sichtfelds mit höherer Auflösung, wobei das Verfahren gleichzeitiges in situ-Analysieren mehrerer benachbarter Ströme von Proben (3) mittels eines Qualitäts- und Prozessüberwachungssystems (QPC-Systems) durch Durchführung von Messungen an den mehreren benachbarten Strömen von Proben einbezieht, **dadurch gekennzeichnet, dass** besagte Qualitäts- und Prozessüberwachung (QPC) eine Qualitäts- und Prozessüberwachung (QPC) gemäß einem der Ansprüche 1 bis 6 ist.

## Revendications

1. Système de contrôle des processus industriels et de la qualité, QPC, pour l'imagerie par résonance magnétique surun champ de vision étendu etparla suite l'imagerie par résonance magnétique sur une portion dudit champ de vision étendu à une résolution supérieure, danslequel:
- le système comprend au moins un réseau dense de dispositifsde résonance magnétique (1A-1D) conçu pour analyser des courants adjacents d'échantillons (3) de manière simultanée ; danslequel
- le système est portatif ; dans lequel
- chacun desdits dispositifs de résonance magnétique comprend une cage multicouche comprenant:
- un circuit magnétique fermé (301) construit à partir d'aimants permanents forts (301a) et de deux pièces polaires (301b) comprenant une cavité pour échantillon (305), entre lesquelles et dans laquelle on peut introduire un échantillon pour en faire une image, et un réseau d'aimants de parois latérales (301c) quibloquentle flux magnétique au sein du circuit magnétique et de la cavité pour échantillon, le dispositif de résonance magnétique étant par conséquent exempt de champs magnétiques produisant des effets de bords;
- une bobine de gradient globale (303) pour procurer des images de faible résolution sur ledit champ de vision étendu, la bobine de gradient globale s'étendant sur toute la longueur de la cavité pour échantillon et possédant un champ de vision qui recouvre le volume global de ladite cavité pour échantillon ; et
- un réseau de bobines de gradients locales (304) pour procurer des images de haute résolution sur un champ de vision plus petit, les bobines de gradients locales dudit réseau étant disposées par intervalles sur la longueur de ladite cavité pour échantillon de telle sorte que n'importe quel tronçon volumique au sein de la cavité pour échantillon rentre dans le champ de vision d'au moins une des bobines de gradients locales; et danslequel
- le système comprend en outre un système d'alimentation comprenant au moins deux courants d'alimentation adjacents capables de transporter plusieurs échantillons à détecter ou à analyser, chaque courant d'alimentation étant arrangé pour transporter dans un des dispositifs de résonance magnétique, une série de sd its échantillons.

2. Système QPC selon la revendication 1, dans lequel lesdits dispositifs de résonance magnétique dudit réseau dense sont disposés dans un réseau x sur y surz, où x, y et z représentent des nombres entiers supérieurs ou égaux à 0.

3. Système QPC selon la revendication 1, dans lequel des bobinesde gradients adjacentes (304) se chevauchent.

4. Système QPC selon la revendication 1, comprenant en outre des moyens numérisés (10A) pour le partage de temps d'au moins un élément choisi parmi le groupe comprenant une alimentation de gradient (10B), une émission/transmission et/ou une amplification RF (10C), une réception RF (10D), un traitement des signaux numériques (10E) ou l'une quelconque d e leurs combinaisons.

5. Système QPC selon la revendication 1, dans lequel, pour chaque dispositif de résonance magnétique, le système d'alimentation comprend une courroie transporteuse qui est arrangée pour transporter un échantillon dans une zone de champ magnétique uniforme dansla cavité pour échantillon.

6. Système QPC selon la revendication 5, dans lequel chaque dispositif de résonance magnétique comprend en outre une bobine de gradient autour de ladite courroie transporteuse.

7. Procédé pour la réalisation d'une imagerie par résonance magnétique sur un champ de vision étendu et par la suite d'une imagerie par résonance magnétique sur une portion dudit champ de vision étendu à une résolution supérieure, le procédé impliquant une a na lyse simultanée in situ de plusieurs courants adjacents d'échantillons (3) au moyen d'un système de contrôle des processus industriels et de la qualité, QPC, pour procéder à des mesures desdits plusieurs courants adjacents d'échantillons, **caractérisé en ce que** ledit QPC est un QPC selon l'une quelconque des revendications 1 à 6.
